# EUROPEAN PATENT APPLICATION

(11) **EP 3 327 067 A1**
(43) Date of publication of application: **30.05.2018**
(21) Application number: 16382552.4
(22) Date of filing: 23.11.2016
(51) Int. Cl.: C08J 5/18, H01L 41/45

(54) **METHOD FOR MANUFACTURING A FILM MADE OF POLYVINYLIDENE FLUORIDE AND FILM MADE OF POLYVINYLIDENE FLUORIDE IN BETA PHASE**

(71) Applicant: Fundación BCMaterials - Basque Center for Materials, Application and Nanostructures, 48940 Leioa (ES)
(72) Inventor: TEIXEIRA CASTRO LOPES, Ana Catarina, 48160 DERIO (ES)
(74) Representative: Igartua, Ismael

(57) **Abstract**

Method for manufacturing a non-porous PVDF film (4) comprising the steps of preparing a solution (2) comprising PVDF, a solvent for the PVDF and an ionic liquid wherein the weight ratio of the PVDF in the solution is between 1:99 and 20:80 and the weight percentage of the ionic liquid with respect to the PVDF is between 5 and 10%, impregnating at least one part of a substrate (1) with said solution (2), incubating said substrate (1) at a temperature which causes the melting of the PVDF and the evaporation of the solvent, a film comprising PVDF and ionic liquid being formed on the substrate (1), leaving the film to crystallize and introducing the substrate (1) in a liquid wherein the ionic liquids are dissolved in said liquid. Non-porous three-dimensional PVDF film (4).

## Description

### TECHNICAL FIELD

The present invention relates to the field of polymers, specifically to non-porous films of polyvinylidene fluoride (hereinafter PVDF) in beta phase and to the method for manufacturing said films.

### PRIOR ART

The PVDF polymer can be in alpha, beta or gamma phase, where beta phase shows the best piezoelectric properties. Due to this feature, there is increasing interest in non-porous and/or transparent films of PVDF in beta phase for the incorporation thereof on the surface of different kinds of products, such as on the surface of sensors, of electronic circuits, prostheses, human tissues, etc. These surfaces consisting of diverse compositions are often not flat, but rather have three-dimensional shapes, so the PVDF film must acquire the same shape of the substrate or base on which it is going to be incorporated, i.e., a three-dimensional shape. Furthermore, according to the end use of the film, said film must be made up of biocompatible elements and it must be flexible enough so as to assure functionality throughout its service life in the intended device.

Different methods for manufacturing PVDF films are known in the prior art. One of the most widely used is the method for manufacturing by means of stretching or double stretching of the PVDF in alpha phase.

Patent document US2005127573 A1 discloses a method for manufacturing a PVDF film comprising up to 49% PVDF in beta phase and semiconducting particles dispersed in the film. For manufacturing this film, first a solution comprising PVDF is prepared in a solvent to which the semiconducting particles are incorporated. Then the solution is melted on a substrate, the solvent evaporated, the film dried and an electric potential applied to the substrate keeping it on two metal plates.

Patent document US6251506 B1 discloses a three-dimensional article formed from a laminar structure comprising a PVDF film with a thickness between 10 and 100 µm adhered to another thermoformable polymer film having a thickness between 100 and 6000 µm.

### DISCLOSURE OF THE INVENTION

The object of the invention is to provide a method for manufacturing a PVDF film and a film, as defined in the claims.

A first aspect of the invention relates to a method for manufacturing a PVDF film comprising the following steps:
- preparing a solution comprising PVDF, a solvent for the PVDF and an ionic liquid wherein the weight ratio of the PVDF in the solution is between 1:99 and 20:80, and the weight percentage of the ionic liquid with respect to the PVDF is between 5 and 10%;
- impregnating at least one part of a substrate with said solution;
- incubating at least one part of said substrate at a temperature which causes the melting of the PVDF and the evaporation of the solvent, a film comprising PVDF and ionic liquid being formed on the substrate;
- leaving the film to crystallize; and
- introducing the substrate with the crystallized film in a liquid wherein the ionic liquids are dissolved in said liquid, and optionally detaching the film from said substrate in a later step; or
- detaching the crystallized film from said substrate and introducing said film in a liquid wherein the ionic liquids are dissolved in said liquid.

The method of the invention obtains a non-porous film, wherein at least 95% of said PVDF is in beta phase and the dielectric permittivity of said film at room temperature and at a frequency of 1 KHz is between 9 and 13.

The method of the invention is a simple and controllable method in which starting from conventional laboratory or production plant materials and equipment, a biocompatible PVDF film is obtained that adapts to three-dimensional surfaces without tearing. In addition to comprising at least 95% of the PVDF in beta phase, this PVDF film has a crystallinity and elasticity similar to those of PVDF in alpha phase obtained by melting. This method furthermore allows mass producing the three-dimensional non-porous PVDF films, which may subsequently be incorporated in devices or surfaces containing materials that cannot be subjected to the conditions of the method of manufacture, such as human prostheses or human tissues.

A second aspect of the invention relates to a non-porous PVDF film, wherein at least 95% of said PVDF is in beta phase and the dielectric permittivity of said film at room temperature and at a frequency of 1 KHz is between 9 and 13, said film having a three-dimensional shape.

These and other advantages and features of the invention will become evident in view of the drawings and the detailed description of the invention.

### DESCRIPTION OF THE DRAWINGS

Figures 1A to 1F show the steps of the method of manufacture according to an embodiment of the invention.
Figure 2 shows one of the steps of the method for manufacturing a film according to a second embodiment of the invention.
Figure 3 shows a scanning electron micrograph of the PVDF film according to an embodiment of the invention.
Figure 4 shows a spectrum of the PVDF film according to the embodiment of the invention of Figure 3 obtained by a Fourier transform spectrophotometer.
Figure 5 shows a thermograph obtained by differential scanning calorimetry according to the embodiment of the invention of Figure 3.

### DETAILED DISCLOSURE OF THE INVENTION

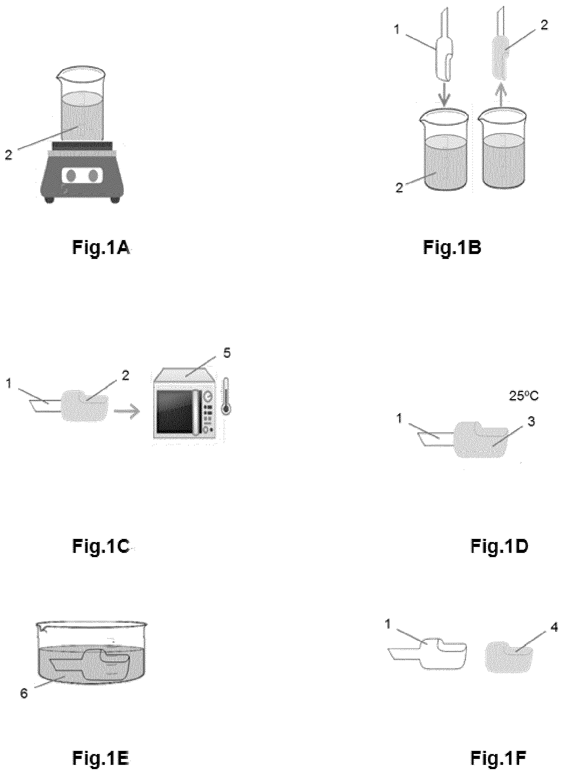

The method for manufacturing a non-porous PVDF film, wherein at least 95% of said PVDF is in beta phase and the dielectric permittivity of said film at room temperature and at a frequency of 1 KHz is between 9 and 13, comprises the following steps:
- preparing a solution 2 comprising PVDF, a solvent for the PVDF and an ionic liquid wherein the weight ratio of the PVDF in the solution is between 1:99 and 20:80, and the weight percentage of the ionic liquid with respect to the PVDF is between 5 and 10%, depicted in Figure 1A;
- impregnating at least one part of a substrate 1 with said solution, depicted in Figure 1 B;
- incubating 5 said substrate 1 at a temperature which causes the melting of the PVDF and the evaporation of the solvent, a film comprising PVDF and ionic liquid being formed on the substrate, depicted in Figure 1C;
- leaving the film to crystallize at a temperature at which the film crystallizes, depicted in Figure 1 D;
- introducing the substrate with the crystallized film 3 in a liquid 6, wherein the ionic liquids are dissolved in said liquid, depicted in Figure 1 E;
- and optionally detaching the resulting film 4 from said substrate 1, depicted in Figure 1F.

In another embodiment, after the film crystallizes, said film 3 is detached from the substrate 1 and introduced in the liquid 6 wherein the ionic liquids are dissolved in said liquid, the film 4 thereby being obtained.

In a preferred embodiment, crystallization is performed at room temperature, which corresponds to a temperature of 22°C ±4°C.

In the context of the invention, non-porous PVDF film is understood as a PVDF film which neither shows nor displays pores by SEM microscopy.

The dielectric permittivity of said film at room temperature and at a frequency of 1 KHz of between 9 and 13 is typical of PVDF films wherein at least 95% of the PVDF is in beta phase.

In a preferred embodiment, incubation is performed between 170°C and 210°C for a time between 5 and 15 minutes. This temperature range and this incubation time favor the PVDF melting and induce the crystallization of PVDF in beta phase in an optimized manner.

The substrate on which the film of the invention is manufactured can have a two-dimensional or flat surface, or else a three-dimensional surface. This substrate can furthermore be a mold having the three-dimensional shape of the object or of the product on which the PVDF film will subsequently be deposited. Therefore, as a result of the method of manufacture, the film acquires the same three-dimensional shape as the mold.

Preferably, the substrate is glass, polytetrafluoroethylene or a metallic material. These materials are characterized by not dissolving in the solvent and by withstanding the incubation temperatures.

In reference to the solvent, the person skilled in the art knows to use different solvents for dissolving PVDF. In a preferred embodiment, the solvent used is dimethylformamide, dimethylacetamide, dimethylsulfoxide or tetrahydrofuran.

As regards the ionic liquids, such liquids are salts in liquid state at temperatures less than 100°C. They are characterized by having a vapor pressure almost equal to zero, insignificant flammability, high thermal stability and a low melting point.

The ionic liquid causes the crystallization of PVDF in beta phase due to electrostatic interactions between the charges of the ionic liquid and the dipolar groups of the polymer chain. These interactions give rise to the PVDF monomers preferably being arranged in the *trans* conformation, therefore inducing the crystallization of the PVDF in the beta phase.

In a preferred embodiment, the ionic liquid is hydrophilic. By way of non-limiting example, the ionic liquid can be [*C*₂*min*][*BF*₄].

Once the PVDF film crystallizes, the ionic liquid present in said film must be removed, so it is introduced in a liquid so that the ionic liquids dissolve in it.

In a preferred embodiment, it is introduced in a liquid with a temperature less than 80°C for at least one hour. These conditions virtually assure complete removal of the ionic liquid both from within and from the surface of the film, keeping the PVDF in beta phase.

In a preferred embodiment in which the ionic liquid is hydrophilic, the liquid in which the film is introduced is distilled water. In addition to lowering costs of manufacturing processes in the case of large-scale productions, this combination has fewer drawbacks from an environmental perspective.

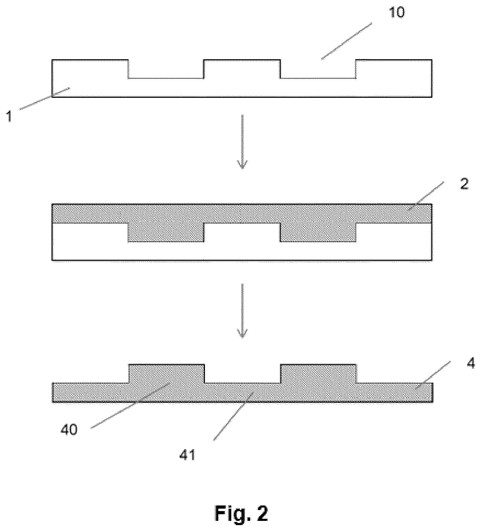

The PVDF film may require different thicknesses depending on the use that is made of said film. A film with a thickness of at least 1 µm can be obtained with the method of the invention. In a preferred embodiment, the obtained film has a thickness between 1 and 70 µm. Nevertheless, one and the same film must sometimes have different thicknesses. In this sense, as illustrated in Figure 2, one embodiment uses a substrate 1 having grooves or cavities 10 on which the solution 2 containing PVDF, ionic liquid and solvent is impregnated, from which after applying the remaining steps of the method of the invention, the film 4 is obtained with different thicknesses 40, 41. Films of this type are very useful as rectangular- or dome-shaped piezoelectric touch sensors.

In another embodiment, at least one part of the substrate is subjected to more than one impregnation and incubation process, giving rise to a variable thickness throughout the non-porous PVDF film. The different impregnation and incubation processes can furthermore be performed with solutions comprising PVDF-ionic liquid-solvent having different viscosities.

In another embodiment, different thicknesses are obtained by means of the movement of the polymer solution due to gravity during the impregnation and/or incubation phase.

Variable thicknesses of this type are required, for example, in touch or pressure sensors, since one and the same pressure on the film generates a different voltage, depending on its thickness.

In order for the PVDF film of the invention to be used as a piezoelectric element it must be polarized. In a particular embodiment, the PVDF film obtained by the method is polarized under electric fields greater than 50 MV/m.

The surfaces to which the PVDF film of the invention is incorporated sometimes contain materials that do not withstand or cannot be subjected to the conditions of the method of manufacture. One of the advantages of the method is that it allows manufacturing the film in a mold of the intended surface. Once the PVDF film of the invention has been manufactured, it can be detached from the mold on which it has been manufactured and then be adhered onto the intended surface. As discussed above, this surface can be a three-dimensional surface, i.e., a surface with protuberances. The PVDF film obtained by the method of the invention has a Young's modulus value between 5 x 10⁸ and 2 x 10⁹ N/m². The lower the Young's modulus value is, the greater the elasticity is. Once the film of the invention has been incorporated, it adapts to the intended surface without tearing.

The method of the invention can therefore be used for manufacturing prostheses that can be implanted in the human or animal body.

The method of the invention is also applicable in processes for manufacturing rectangular- or dome-shaped piezoelectric touch sensors, among others.

A second aspect of the invention relates to a PVDF film characterized in that it is a three-dimensional non-porous film comprising at least 95% of the PVDF in beta phase, the dielectric permittivity of said film at room temperature and at a frequency of 1 KHz being between 9 and 13, as described above in reference to the method of manufacture with three-dimensional molds or substrates.

In a preferred embodiment, the film of the invention consists of PVDF.

In other embodiments, the film of the invention comprises other additives or substances, such as dyes, stabilizers, disinfectants, antibiotics, etc., in addition to PVDF.

Another aspect of the invention relates to a three-dimensional substrate, characterized in that has a PVDF film of the invention adhered thereto. Depending on the use that will be made of the substrate, the adhesion may or may not be removable.

This substrate can be glass, polytetrafluoroethylene or a metallic material. This substrate can be part of medical devices, for example a catheter, artificial sensory tissue or prosthesis, among others.

Several illustrative examples showing the features and advantages of the invention are described below; nevertheless, they must not be construed as limiting the object of the invention as it is defined in the claims.

Example 1: Manufacturing a three-dimensional non-porous PVDF film wherein at least 95% of the PVDF is in beta phase.

A first solution comprising 1 g of PVDF, 0.11 g of 1-ethyl-3-methylimidazolium chloride ([*C*₂*min*][*Cl*]) as the ionic liquid and 4 ml of dimethylformamide as the solvent is prepared.

A three-dimensional glass mold is impregnated with said solution. Said mold is introduced in an oven at 200°C and incubated for 10 minutes, during which time the PVDF melts and the solvent evaporates. The film is then left to crystallize at room temperature. During incubation and crystallization, the mold is subjected to a constant rate of rotation to obtain a homogenous film thickness throughout the mold.

The mold is then introduced in a distilled water bath at 70°C for an hour until the ionic liquid is completely removed from the PVDF film. The film is then detached from said mold.

This manufacturing process has also been carried out with a second solution containing 0.125 g of PVDF, 0.01375 g of 1-ethyl-3-methylimidazolium tetrafluoroborate ([*C*₂*min*][*BF*₄]) as the ionic liquid and 16 ml of dimethylformamide as the solvent.

### Example 2: Characterization of the film obtained with the first solution of Example 1

### Film thickness: 48 µm

### Scanning electron micrograph:

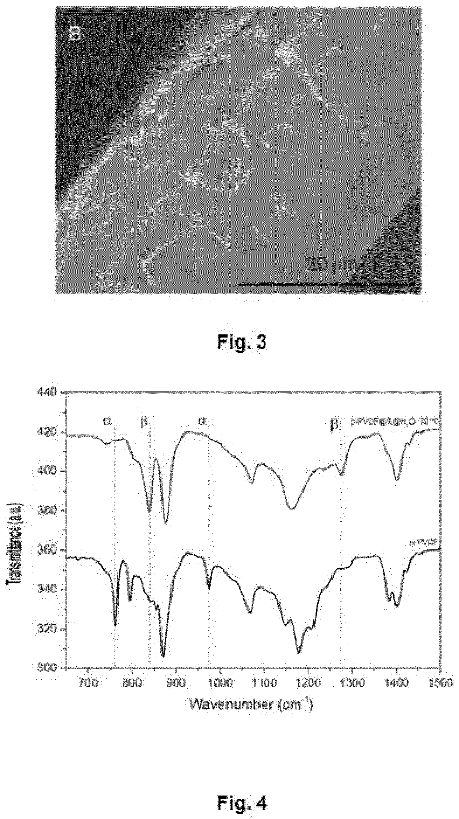

As depicted in Figure 3, a scanning electron micrograph of a sample of the film was obtained by means of a Hitachi TM3000 Tabletop Scanning Electron Microscope. Photograph 1 consists of an image of the cross section of said film in which the absence of pores is observed.

### Fourier transform spectrophotometry:

The equipment used was Jasco FT/IR-6100. Figure 4 shows the spectrum of α-PVDF obtained from a sample of film obtained by melting PVDF without the presence of the ionic liquid and the spectrum of β-PVDF@IL@H₂O-70°C obtained from a sample of film obtained according to Example 1. It can be seen that the film obtained without the presence of ionic liquid crystallizes in the alpha phase, confirmed by the presence of bands at 766, 795 and 976 cm⁻¹. In contrast, the samples obtained according to Example 1 crystallize in the beta phase, confirmed by the presence of bands at 840 and 1279 cm⁻¹ and the absence of alpha phase bands, furthermore indicative that 100% of the PVDF comprised in the film is in beta phase.

### Differential scanning calorimetry thermograph:

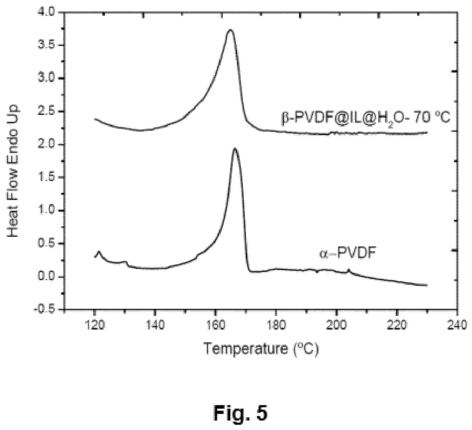

Figure 5 shows one thermogram for α-PVDF and another one for β-PVDF@IL@H₂O-70°C obtained by differential scanning calorimetry of a sample of PVDF film without the presence of the ionic liquid and of a sample of film prepared according to Example 1, respectively. The melting temperature and the enthalpy of fusion value in both are similar, indicative of the similarity in the degree of crystallinity of both samples.

### Dielectric permittivity:

The dielectric permittivity of a sample of film obtained according to Example 1 and of a sample of film obtained by the method of the invention to which the step of Figure1E has not been applied has been calculated using an Agilent E4980A precision LCR meter. At a frequency of 1 KHz at room temperature, a dielectric permittivity value of 13 has been obtained for the first sample and a value of 36 for the second sample.

### Young's modulus:

Young's modulus value was obtained through the DEBEN-Microtest tensile stage controller, with a 200N load cell at a draw rate of 1 mm/min of a sample of film according to Example 1 and of a sample of film obtained by the method of the invention to which the step of Figure 1E has not been applied.

The value obtained was 9.4 x 10⁸ N/m² for the first sample and 8.28 x 10⁸ N/m² for the second sample.

### Polarization and obtaining the value of piezoelectric coefficients:

The film obtained according to Example 1 was polarized by the corona effect under electric fields of 50 MV/m, and the value of piezoelectric coefficients d33 and d31 was measured, obtaining a value from -18 to -36 pC/N for the first and between 8 and 23 pC/N for the second. The polarization was established by applying an electric field using a Hitek Power Series 400 power source, first at a temperature of 80°C for one hour and then until the film temperature reaches room temperature. Piezoelectric coefficient d33 was measured with APC International, Ltd. Wide Range d33 tester. Piezoelectric coefficient d31 was measured according to the method described in "Uchino K. Ferroelectric Devices. New York: Marcel Dekker Inc., 2000."

## Claims

1. Method for manufacturing a non-porous PVDF film, **characterized in that** it comprises the following steps:
- preparing a solution comprising PVDF, a solvent for the PVDF and an ionic liquid wherein the weight ratio of the PVDF in the solution is between 1:99 and 20:80, and the weight percentage of the ionic liquid with respect to the PVDF is between 5 and 10%;
- impregnating at least one part of a substrate with said solution;
- incubating at least said part of said substrate at a temperature which causes the melting of the PVDF and the evaporation of the solvent, a film comprising PVDF and ionic liquid being formed on the substrate;
- leaving the film to crystallize; and
- introducing the substrate with the crystallized film in a liquid wherein the ionic liquids are dissolved in said liquid, and optionally detaching the film from said substrate in a later phase; or
- detaching the crystallized film from said substrate and introducing said film in a liquid wherein the ionic liquids are dissolved in said liquid.

2. Method according to claim 1, wherein incubation is performed between 170°C and 210°C for a time between 5 and 15 minutes.

3. Method according to claim 1 or 2, wherein the substrate is introduced in a liquid with a temperature less than 80°C for at least one hour.

4. Method according to any of the preceding claims, wherein the substrate is a three-dimensional mold and the non-porous film acquires the same three-dimensional shape as the mold.

5. Method according to any of the preceding claims, wherein the substrate is glass, polytetrafluoroethylene or a metallic material.

6. Method according to any of the preceding claims, wherein the solvent is dimethylformamide, dimethylacetamide, dimethylsulfoxide or tetrahydrofuran.

7. Method according to any of the preceding claims, wherein the ionic liquid is hydrophilic.

8. Method according to claim 7, wherein the ionic liquids are dissolved in distilled water.

9. Method according to any of the preceding claims, wherein at least one part of the substrate is subjected to more than one impregnation and incubation process, giving rise to variable thickness throughout the non-porous film.

10. Method according to any of the preceding claims, wherein during the impregnation and/or incubation phase the solution moves over the substrate due to gravity, giving rise to variable thickness throughout the non-porous film.

11. Method according to any of the preceding claims, wherein the film is polarized under electric fields greater than 50 MV/m.

12. PVDF film, **characterized in that** it is a three-dimensional non-porous film comprising at least 95% of the PVDF in beta phase, the dielectric permittivity of said film at room temperature and at a frequency of 1 KHz being between 9 and 13.

13. PVDF film according to claim 12, comprising a Young's modulus value between 5 x 10⁸ and 2 x 10⁹ N/m².

14. PVDF film according to claim 12 or 13, comprising a thickness of at least 1 µm.

15. PVDF film according to any of claims 12 to 14, comprising a variable thickness throughout the film.
